(19) Europäisches Patentamt
European Patent Office
Office européen des brevets

(11) EP 0 832 858 A2

(12) **EUROPEAN PATENT APPLICATION**

(43) Date of publication:
**01.04.1998 Bulletin 1998/14**

(21) Application number: **97116718.4**

(22) Date of filing: **25.09.1997**

(51) Int. Cl.$^6$: **C03C 8/24**, G02B 6/12, G11B 5/127, H01L 23/10, H01L 23/29

(84) Designated Contracting States:
**AT BE CH DE DK ES FI FR GB GR IE IT LI LU MC NL PT SE**

(30) Priority: **26.09.1996 JP 254239/96**

(71) Applicant: **HITACHI, LTD.**
**Chiyoda-ku, Tokyo 101 (JP)**

(72) Inventors:
- **Yamamoto, Hiroki**
**Hitachi-shi, Ibaraki 316 (JP)**
- **Naito, Takashi**
**Hitachioota-shi, Ibaraki 313 (JP)**
- **Namekawa, Takashi**
**Hitachi-shi, Ibaraki 317 (JP)**
- **Suzuki, Yasutaka**
**Taga-gun, Ibaraki 319-13 (JP)**
- **Motowaki, Shigehisa**
**Minami-ku, Yokohama-shi, Kanagawa 232 (JP)**

(74) Representative:
**Beetz & Partner**
**Patentanwälte**
**Steinsdorfstrasse 10**
**80538 München (DE)**

(54) **Sealing glass, and a method for manufacturing the same**

(57) A glass sealed body, wherein a residual stress is desirably small, and the stress is controlled precisely, is provided, and magnetic heads, plasma display panels, semiconductor sensors, and optical devices of high production yield, high reliability, and high performance are obtained.

The glass sealed body comprises a sealing glass (1) and a substrate (2), and has a relationship expressed by the equation, R1 < R2, where, R1 is a retardation of the glass portion, and R2 is a retardation of the glass portion after re-heating and cooling to room temperature by an average cooling velocity of utmost 20 °C/minute.

FIG. 5

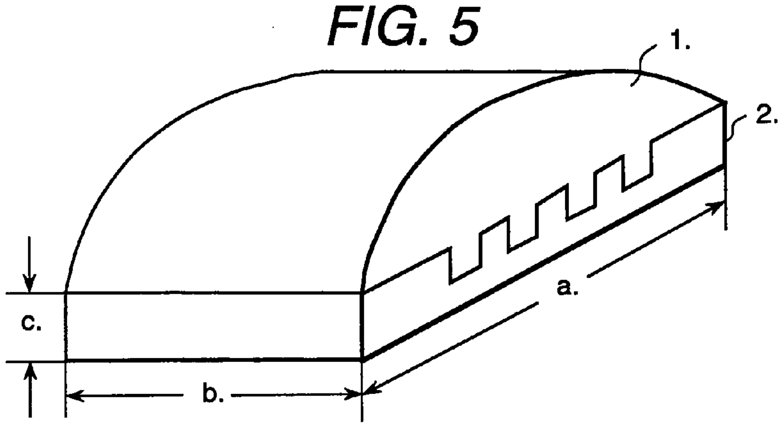




Printed by Xerox (UK) Business Services
2.15.12/3.4

## Description

### BACKGROUND OF THE INVENTION

The present invention relates to a sealing glass and a method for manufacturing the same, particularly to sealing glass wherein a stress is precisely controlled, magnetic heads having a high performance, plasma display panels having a high sealing strength, semiconductor sensors having small fluctuation in characteristics, optical devices having a small lose, and methods for manufacturing the same.

Since the sealing glass is used both for encapsulating a body, and for bonding two bodies, the word "seal" means either of "encapsulate" and "bond" in the present invention.

In order to seal magnetic heads, semiconductors, electronic tubes, and others, a sealing glass, which is capable of sealing the above members at a temperature lower than their resisting temperature, is used. A glass sealed body having a small residual stress after cooling can be obtained by using a sealing glass which can be accommodated with a thermal expansion coefficient of the members. However, currently, effects of the stress caused by glass to characteristics of electronic members have been becoming not negligible. Regarding optical members such as the optical devices using glass, an influence such that their losses are increased by a stress caused by combining mutually different kinds of glasses is generated. In order to solve the above problems, controlling the characteristics of the members by controlling the stress precisely became necessary.

One of the methods to control the stress in a glass sealed body is to control the stress by varying a thickness of reaction layer generated between the glass and the sealed body, as disclosed in JP-A-8-91950 (1996).

Another method to accommodate the stress in the glass bonded portion by the steps of sealing a substrate with a sealing glass, cooling the sealed body to room temperature, re-heating, and re-cooling gradually is disclosed in JP-A-63-69009 (1988).

However, in accordance with the method disclosed in the above JP-A-8-91950 (1996), a presence of the reaction layer is necessary, and furthermore, controlling elements composing the reaction layer is also necessary in order to satisfy a desired characteristics. Therefore, it is difficult to make the method generic irrelevant to a composition of materials. Accordingly, regarding a general glass sealed body irrelevant to its material composition, it is difficult to control precisely a wide range of stresses from compression to tension by varying the stress loaded to both the glass material and the sealed body with maintaining the composition unchanged. The method disclosed in JP-A-63-69009 (1988) had a problem to be worried about a residual stress which still remained even after re-heating, because the sealed body was cooled once to room temperature, and cracks which were generated in the substrate or in the sealing glass by cooling once to room temperature. Furthermore, its production process required a long time, because the sealed body was reheated after cooling to room temperature.

### SUMMARY OF THE INVENTION

One of the objects of the present invention is to provide a method for eliminating the residual stress at a bonded portion in a glass sealed body most efficiently in a short time in comparison with the prior art.

Another one of the objects of the present invention is to provide a sealed body having a small stress at a bonded portion in comparison with the prior art.

In accordance with the first invention of the present invention to realize the above objects, a glass sealed body comprising at least a glass and a substrate, which is sealed with the glass characterized in having a relationship of $R1 < R2$, is provided. Where, R1 is a retardation of the glass at room temperature, and R2 is a retardation of the glass after reheating the glass sealed body at a temperature exceeding the deformation temperature of the sealing glass once, and subsequently cooling by an average cooling velocity of utmost 20 °C/minute. The "retardation" in the present invention means a phase difference which is caused by varying optical refractive index in a stress axis direction in the presence of the stress with the glass. The retardation can be determined by a birefringence method using a monochrome light source. The larger retardation indicates a larger stress.

A relationship of $R1 < R2$ means, in other words, a body characterized in being sealed by a glass having a smaller stress than a stress in a body which is sealed with the sealing glass and simply cooled gradually (an average cooling velocity is utmost 20 °C/minute). The retardation is determined on the sealed body itself, that is, in a condition of not-separated to the sealing glass and the substrate, using a He-Ne laser of wave length 650 nm as a light source.

In accordance with the above composition, a glass sealed body having a high reliability, of which sealing glass will not generate any cracks even after being used for a long time, can be provided. When the sealed body is an optical device, the optical device having a small optical energy loss can be provided.

In accordance with the second invention of the present invention to realize the above objects, a method of manufacturing a glass sealed body comprising the steps of contacting a sealing glass with a substrate, heating the sealing glass at a temperature exceeding the deformation temperature of the glass, cooling the sealing glass to a temperature between the deformation temperature of the glass and room temperature with an average cooling velocity of utmost 20 °C/minute, subsequently, holding the sealing glass for a predetermined time at a temperature in a range of the glass transformation temperature ± 10 °C of the glass, and cooling the sealing glass from the holding to room temperature with an average cooling velocity of utmost 20 °C/minute is provided.

In the above second invention, the thermal expansion coefficient of the sealing glass is desirably in the range of 65 ~ 105 % of the thermal expansion coefficient of the substrate. The above combination is the most expedient to decrease the stress in the glass bonded portion.

In accordance with the third invention of the present invention, a magnetic head comprising at least two magnetic cores, which are butted each other and sealed with a sealing glass, wherein the sealing glass is characterized in having a relationship of $R1 < R2$, is provided. Where, R1 is a retardation of the glass at room temperature, and R2 is a retardation of the glass after re-heating the magnetic head at a temperature exceeding the deformation temperature of the sealing glass once, and subsequently cooling by an average cooling velocity of utmost 20 °C/minute.

In accordance with the above composition, the magnetic head, of which sealing glass will not generate many cracks at the bonding portion can be provided. Furthermore, the glass has a desirable bonding strength.

In accordance with the fourth invention of the present invention, a method of manufacturing a magnetic head comprising the steps of butting at least two magnetic cores, contacting the magnetic cores with a sealing glass, heating the sealing glass at a temperature exceeding the deformation temperature of the glass, cooling the sealing glass to a temperature between the deformation temperature of the glass and room temperature with an average cooling velocity of utmost 20 °C/minute, subsequently, holding the sealing glass for a predetermined time at a temperature in a range of the glass transformation temperature ± 10 °C of the glass, and cooling the sealing glass from the holding temperature to room temperature with an average cooling velocity of utmost 20 °C/minute is provided.

In accordance with the above fourth invention, the magnetic head having a less distortion in the bonding portion can be obtained in a short time.

In the above fourth invention, the thermal expansion coefficient of the sealing glass is desirably in the range of 70 ~ 95 % of the thermal expansion coefficient of the magnetic core.

In accordance with the fifth invention of the present invention, a plasma display panel comprising a discharge cell, which is partitioned with a separator and applied with a fluorescent substance, and two glass plates, which hold the discharge cell between them, and electrodes and dielectric films are formed on inner walls of the glass plates, and the two glass plates are bonded to the discharge cell with a sealing glass, wherein the glass plates are characterized in having a relationship of $R2_s < R1_s$, is provided. Where, $R1_s$ is a retardation of the glass plate after bonding at room temperature, and $R2_s$ is a retardation of the glass plate after re-heating the plasma display panel at a temperature exceeding the deformation temperature of the sealing glass once, and subsequently cooling by an average cooling velocity of utmost 20 °C/minute. The reason why the relationship of the $R1_s$ and $R2_s$ is reversed is because the sealing glass for the plasma display panel contains a filler and has a poor transparency, and accordingly, the stress in the panel glass is evaluated. That means, since the object of determining the retardation is reversed from that of the first invention, the relationship of the retardation is also reversed.

In accordance with the above composition, the plasma display panel, wherein the number of flawed discharge cells are small because of less defects at the bonded portion, and the size of the display panel is readily increased, can be obtained.

In accordance with the sixth invention of the present invention, a method of manufacturing a plasma display panel comprising the steps of forming a separator, applying a fluorescent substance onto a discharge cell partitioned with the separator, forming electrodes and dielectric films on glass plates, holding the separator with the glass plates between and arranging a sealing glass having a thermal expansion coefficient in the range of 70 ~ 95 % of the thermal expansion coefficient of the glass plate around the glass plates, heating the whole body at a temperature exceeding the deformation temperature of the sealing glass for sealing the whole body, cooling the whole body to a temperature in a range of the glass transformation temperature ± 10 °C of the glass with an average cooling velocity of utmost 20 °C/minute, subsequently, holding the whole body for a predetermined time at a temperature in a range of the glass transformation temperature ± 10 °C of the glass, and cooling the whole body to room temperature with an average cooling velocity of utmost 20 °C/minute is provided.

In accordance with the above sixth invention, a short production process of the plasma display panel with a high production yield can be provided.

In accordance with the seventh invention of the present invention, a semiconductor sensor comprising a metallic post, a semiconductor substrate whereon a sensor is formed, a glass plate which is bonded to the back face of the semiconductor substrate, and a sealing glass which seals both the metallic post and the glass plate, wherein the glass plates are characterized in having a relationship of $R2_s < R1_s$, is provided. Where, $R1_s$ is a retardation of the glass plate after sealing at room temperature, and $R2_s$ is a retardation of the glass plate after re-heating the semiconductor sensor at a temperature exceeding the deformation temperature of the sealing glass once, and subsequently cooling by an average cooling velocity of utmost 20 °C/minute.

In accordance with the above composition, the semiconductor sensor having a high reliability, which scarcely generates separation of the glass plates, and cracks, can be provided.

In accordance with the eighth invention of the present invention, a method of manufacturing a semiconductor sensor comprising the steps of bonding a semiconductor substrate, whereon a sensor is formed, with a glass plate, arranging a sealing glass between a metallic post and the glass plate, heating the whole body at a temperature exceeding the deformation temperature of the sealing glass for sealing the whole body, cooling the whole body to a temperature in a range of the glass transformation temperature ± 10 °C of the sealing glass with an average cooling velocity of utmost 20 °C/minute, subsequently, holding the whole body for a predetermined time at a temperature in a range of the glass transformation temperature ± 10 °C of the sealing glass, and cooling the whole body to room temperature with an average cooling velocity of utmost 20 °C/minute is provided.

In accordance with the above composition, a semiconductor sensor having a high reliability can be manufactured in a short time.

In accordance with the ninth invention of the present invention, an optical device comprising at least a glass substrate, whereon a glass wave guide film is formed, and a cover glass film covering the glass wave guide film, wherein the glass wave guide film is characterized in having a relationship of R1 < R2, is provided. Where, R1 is a retardation of the glass wave guide film at room temperature, and R2 is a retardation of the glass wave guide film after re-heating the optical device at a temperature exceeding the deformation temperature of the glass wave guide film, and subsequently cooling by an average cooling velocity of utmost 20 °C/minute.

In accordance with the above composition, the optical device scarcely having distortion in the glass wave guide film, accordingly the loss of the optical energy is scarce, can be provided.

In accordance with the tenth invention of the present invention, a method of manufacturing an optical device comprising the steps of forming a glass wave guide film on a glass substrate, heating the whole body at a temperature exceeding the deformation temperature of the glass wave guide film for densifying the glass wave guide film, cooling the whole body to a temperature in a range of the glass transformation temperature ± 10 °C of the glass wave guide film with an average cooling velocity of utmost 20 °C/minute, subsequently, holding the whole body for a predetermined time at a temperature in a range of the glass transformation temperature ± 10 °C of the glass wave guide film, cooling the whole body to room temperature with an average cooling velocity of utmost 20 °C/minute, shaping the glass wave guide film into a shape of wave guide path, and forming a cover glass film onto the upper surface of the body, is provided.

In accordance with the above composition, an optical device, of which loss of the optical energy is scarce, can be manufactured with a high production yield in a short time.

BRIEF DESCRIPTION OF THE DRAWINGS

The above and further objects and novel feature of the present invention will more fully appear from the following detailed description when the same is read in connection with the accompanying drawings. It is to be expressly understood, however, that the drawings are for purpose of illustration only and are not intended as a definition of the limits of the invention.

FIG. 1 is a graph indicating a relationship between a holding temperature and an amount of warp of the glass sealed body of the present invention,

FIG. 2 is a graph indicating a relationship between a holding temperature and an amount of warp of the glass sealed body of the present invention,

FIG. 3 is a graph indicating a relationship between a holding temperature and an amount of warp of the glass sealed body of the present invention,

FIG. 4 is a graph indicating a relationship between a holding temperature and an amount of warp of the glass sealed body of the present invention,

FIG. 5 is a schematic illustration indicating an appearance of the glass sealed body of the present invention,

FIG. 6 is a schematic illustration indicating a process for manufacturing an example of the glass sealed bodies of the present invention,

FIG. 7 (a) and FIG. 7 (b) are schematic cross sections of the glass sealed bodies of the present invention indicating a relationship between the warp and stresses in the glass sealed body,

FIG. 8 is a graph indicating a profile of glass sealing process of the glass sealed body of the present invention,

FIG. 9 is a graph indicating a relationship between the warp and cooling velocity,

FIG. 10 is a graph indicating a relationship between the warp and the holding temperature, and the re-heated temperature,

FIG. 11 is a graph indicating schematically a manner of glass sealing using thermal expansion curves,

FIG. 12 is a schematic illustration of an appearance of the test piece for measuring stress using a birefringence method of the present invention,

FIG. 13 is a graph indicating a relationship of retardation versus scanning distance,

FIG. 14 is a graph indicating Weibull plots of three points bending strength of the sealing glass examined in the present invention,

FIG. 15 is a schematic perspective view of the magnetic head manufactured by the present invention,

FIGs. 16 (a), 16 (b), and 16 (c) are illustrations indicating a method of manufacturing the magnetic head of the present invention,

FIG. 17 (a) and FIG. 17 (b) are illustrations indicating a method of manufacturing the magnetic head of the present invention,

FIG. 18 is a schematic cross section of the plasma display panel manufactured by the present invention,

FIG. 19 is a schematic cross section of the semiconductor sensor manufactured by the present invention, and

FIG. 20 is a schematic cross section of the optical device manufactured by the present invention.

DESCRIPTION OF THE PREFERRED EMBODIMENTS

Details of the present invention is explained hereinafter using the preferred embodiments.

A residual stress in a glass sealed body caused by a heat treatment was evaluated based on a warp of the substrate using the glass sealed body shown in FIG. 5. In FIG. 5, the numerals 1 and 2 indicate a sealing glass and a substrate, respectively. In accordance with the present embodiment, a Mn-Zn ferrite substrate having dimension of a = 15 mm, b = 7.0 mm, and c= 1.0 mm (thermal expansion coefficient; 115 X $10^{-7}$ /°C) was used.

FIG. 6 schematically indicates the steps of manufacturing the glass sealed body shown in FIG. 5. The first step was to manufacture plural grooves having dimension of d = 0.3 mm, e = 0.3 mm on the upper surface of the Mn-Zn ferrite substrate 2. Then, a sealing glass plate 1, which was manufactured so as to be as same size as the ferrite substrate, was mounted onto the ferrite substrate. The sealing glass was melted and flowed into the grooves on the substrate 1 by a predetermined heat treatment of the sealing glass to obtained the glass sealed body shown in FIG. 5.

A relationship between a direction of the warp of the substrate and a stress applied to the glass is indicated in FIG. 7 (a) and FIG. 7 (b). When the substrate warp in a convex shape as shown in FIG. 7 (a), it can be understood that the shrinkage of the glass is larger than the shrinkage of the ferrite substrate. Accordingly, a tensile stress by the ferrite is generated at the bonded boundary of the glass. This case is referred to positive.

Reversely, when the substrate warp in a concave shape, a compressive stress is generated at the bonded boundary of the glass. This case is referred to negative. The amount of the warp is expressed by a deformation of the substrate at a position far from the center of the substrate (taking as zero) by ± 6.8 mm.

The composition of the sealing glasses used in the present invention are shown in Table 1, and each of the thermal expansion coefficient ($\alpha$ X $10^{-7}$ /°C), the glass transformation temperature (Tg/°C), deformation temperature (Td/°C), working point (Tw/°C; log $\eta$ = 4, $\eta$ : viscosity of the glass/ poise), of the sealing glasses is shown in Table 2. In Table 1, the embodiments No. 1 ~ No. 7 are glass containing lead oxide as a main component. The embodiment No. 8 is boronsilicate glass, and No. 9 and 10 are glass containing vanadium oxide as a main component.

Table 1

| Embodiment No. | Composition (% by weight) | | | | |
|---|---|---|---|---|---|
| | PbO | $SiO_2$ | $B_2O_3$ | ZnO | $Al_2O_3$ |
| 1 | 79 | 3 | 12 | 5 | 1 |
| 2 | 75 | 12 | 7 | - | 5 |
| 3 | 72 | 12 | 7 | - | 4 |
| 4 | 71 | 12 | 8 | 0.5 | 4.5 |
| 5 | 55 | 20 | 8 | 6 | 2 |
| 6 | 64.1 | 16.2 | 10.3 | 3.4 | 1.7 |
| 7 | 57.7 | 19.2 | 7.7 | 1.9 | 6.7 |
| 8 | - | 21 | 29 | 35 | 5 |
| 9 | 5 | - | - | - | - |
| 10 | 6 | - | - | - | - |

Table 1 (continued)

| Embodiment No. | Composition (% by weight) | | | | | |
|---|---|---|---|---|---|---|
| | $Na_2O$ | $V_2O_5$ | $P_2O_5$ | $Sb_2O_3$ | $Tl_2O$ | $Er_2O_3$ |
| 1 | - | - | - | - | - | - |
| 2 | 1 | - | - | - | - | - |
| 3 | 1 | - | - | - | - | - |
| 4 | 2 | - | - | - | - | - |
| 5 | 8 | - | - | - | - | 1 |
| 6 | 3.4 | - | - | - | - | 0.9 |
| 7 | 5.8 | - | - | - | - | 1 |
| 8 | 10 | - | - | - | - | - |
| 9 | - | 55 | 23 | 12 | 5 | - |
| 10 | - | 55 | 23 | 11 | 5 | - |

Table 2

| Embodiment No. | Thermal expansion coefficient ($X10^{-7}$/°C) | Glass transformat ion temperature (Tg/°C) | Deformation temperature (Td/°C) | Working point (Tw/°C) |
|---|---|---|---|---|
| 1 | 99 | 330 | 363 | 470 |
| 2 | 97 | 380 | 423 | 555 |
| 3 | 104 | 373 | 415 | 575 |
| 4 | 91 | 395 | 423 | 600 |
| 5 | 117 | 379 | 418 | 580 |
| 6 | 98 | 380 | 427 | 585 |
| 7 | 103 | 388 | 425 | 596 |
| 8 | 84 | 487 | 535 | 682 |
| 9 | 83 | 343 | 376 | 464 |
| 10 | 80 | 332 | 372 | 465 |

The thermal expansion coefficient was determined by differential dilatometer. The glass transformation temperature (Tg) and the deformation temperature (Td) were determined from the obtained thermal expansion curve, The Tg was determined from the inflection point where the gradient of the curve changes, and the Td was determined from the first point where elongation changes to shrinkage in the temperature increasing test. The temperature increasing velocity was 5 °C/minute. The Tw was determined from the differential thermal analysis curve.

The temperature profile in the sealing process of the glass sealed body of the present embodiment is shown in FIG. 8. The temperature elevating velocity was 5 °C /minute, and the highest temperature T1 was held for 30 minutes. The highest temperature was the Tw of each glass. An average cooling velocity was a definite at 2 °C/minute. During the cooling period, the glass sealed body was held at a temperature T2 for a definite time t2, and variation of stress was analyzed by changing the T2 and t2. The T2 is called as a holding temperature, and the t2 is called as a holding time. During the heat treatment, the heating was performed in nitrogen atmosphere in order to prevent the ferrite from oxidation. At the temperature T1, the atmosphere pressure was reduced by a vacuum pump in order to eliminate bubbles generated in the glass.

The amounts of the warp of the substrate at room temperature, when the time t2 was fixed for 30 minutes and the holding temperature T2 was changed, are shown in FIGs. 1 ~ 4. Concurrently, the amounts of the warp, when the holding at a temperature during the cooling period was not performed but only cooling with a constant cooling velocity was performed, are shown in FIGs. 1 ~ 4. With all the glasses, the amounts of the warp became less in cases when the glass sealed body was held at a temperature for a definite time during the cooling period than the cases when the holding at a temperature during the cooling period was not performed. In accordance with changing the holding temperature, the amount of the warp indicated a minimum value at a temperature specific to each of the glasses, and the amounts of the warp were distributed on two lines which formed a V-shape with a crossing point at the minimum value in the vicinity of the specific temperature.

In comparison with the holding temperature which corresponds to the minimum amount of the warp of each of glasses, it was revealed that the holding temperature corresponding to the minimum amount of the warp was a temperature near the glass transformation temperature Tg of the each glass. Furthermore, it was revealed that the V-shape distribution curves for the glass having a larger thermal expansion coefficient was located at higher temperature range, in other words, the larger the thermal expansion coefficient was, the larger the tensile stress was generated at the glass bonded boundary. Particularly, in the cases of the glass No. 4, and No. 8, the amounts of the warp were changed to negative by holding at a temperature during the cooling period, and it was revealed that the stress applied to the glass was changed from tensile to compressive. In the cases of the vanadium group glasses No. 9 and No. 10, absolute values of gradients of the two lines were significantly large, and it was revealed that the amounts of the warp changed remarkably in a small range of the holding temperature.

As explained above, it was revealed that the tensile stress generated in the glass could be reduced by holding each of the glasses at an appropriate temperature specific to each of the glasses. Furthermore, it was revealed that the stress condition could be controlled from a tensile stress to a compressive stress by selecting an appropriate combination of the glass and the substrate.

The reduction of the stress by holding at a temperature during the cooling period as described above was significant for all the glasses at a temperature in the range of the glass transformation temperature Tg ± 10 °C of the each glass. At a temperature lower than the glass transformation temperature - 10 °C, it took a very long time for reducing the stress, or sometime the stress could not be reduced at all even after holding at a temperature for a sufficiently long time during the cooling period. At a temperature higher than the glass transformation temperature + 10 °C, a new stress was generated in the cooling step at a lower temperature after sealing the glass and the substrate, and the effect of reducing the stress was small.

In the present embodiment, the glasses, of which thermal expansion coefficients were in the range of 65 ~ 105 % of the thermal expansion coefficient of the ferrite, were used. With the glasses having a thermal expansion coefficient outside the above range, any preferable result could not be obtained. Practically, with the glass having a thermal expansion coefficient exceeding 105 % of the thermal expansion coefficient of the substrate, the stress could be reduced by holding at an appropriate temperature during the cooling period. However, the minimum amount of the warp was still large, and generation of cracks in the glass sealed portion was observed with some glass sealed bodies. Accordingly, the thermal expansion coefficient of the sealing glass is desirably less than 105 % of the thermal expansion coefficient of the substrate.

On the other hand, with the glass having a thermal expansion coefficient less than 65 % of the thermal expansion coefficient of the substrate, the stress was sufficiently small without holding at a temperature during the cooling period, and reversely, a large compressive stress was generated in the glass by holding at a temperature during the cooling period. Accordingly, the thermal expansion coefficient of the sealing glass is desirably larger than 65 % of the thermal expansion coefficient of the substrate.

Subsequently, the glass sealed body examined by the above investigation was re-heated to the temperature T1, cooled down by a cooling velocity of 2 °C/minute without holding at a temperature during the cooling period, and an amount of the warp was measured. The amount of the warp was as same as the amount of the warp which was obtained by the first measurement with the specimen without holding at a temperature during the cooling period. Accordingly, it was revealed that the effect of the holding at a temperature during the cooling period was canceled by reducing once the viscosity of the glass sufficiently to relax the stress at a high temperature, and a stress was generated and remained finally in the glass sealed body by cooling in a furnace without holding at a temperature during the cooling period.

Because the amount of the warp could be made smaller by holding the specimen at a temperature during the cooling period than the amount of the warp of the specimen which was not held at a temperature during the cooling period of the specimen, when the amount of the warp of a glass sealed body was increased to larger than the amount of the warp before re-heating by re-heating the glass sealed body and cooling gradually with a definite cooling velocity without holding at a temperature during the cooling period, it could be understood that the glass sealed body was previously treated by holding at a temperature during the cooling period.

Variation in the amount of the warp in accordance with changing the cooling velocity was studied. A relationship between the cooling velocity and the amount of the warp is indicated in FIG. 9. In this embodiment, the glass No. 7 was used. The glass was not held at a temperature during the cooling period. The amount of the warp was reduced with decreasing the cooling velocity. However, the rate of reducing the amount of the warp was small, and such a large reduction as shown in FIG. 1 was not observed. When the cooling velocity exceeded 20 °C/minute, a temperature difference between surface portion and inside of the glass sealed body was caused, and cracks were generated in the glass portion. Accordingly, the cooling velocity is desirably not greater than 20 °C/minute. As explained above, in accordance with the method of manufacturing the glass sealed body of the present invention, the stress in the glass sealed body can be controlled in a wide range from tensile to compressive without changing the glass composition.

Next, a stress in a glass sealed body was evaluated by re-heating the glass sealed body, which had been cooled once to room temperature with a cooling velocity of 2 °C/minute, to the holding temperature explained above, and cooling again to room temperature with a cooling velocity of 2 °C/minute. The glass NO. 7 was used in this evaluation, and test pieces for determining the warp shown in FIG. 5 were prepared. The stress was evaluated from the amount of the warp of the test piece. The amounts of the warp of the test pieces in two cases are shown in FIG. 10. The first case was on the test piece which was held at the holding temperature for 30 minutes during the cooling period, and the second case was on the test piece which was cooled once to room temperature, re-heated to the holding temperature, held at the temperature for 30 minutes, and cooled to room temperature again.

In accordance with the above evaluation, it was revealed that the amount of the warp of the test piece was reduced by re-heating in the second case, but the effect of relaxing the stress was smaller than the first case. Details of this phenomenon is explained hereinafter referring to FIG. 11. FIG. 11 illustrates schematically the bonding the sealing glass and the substrate using each thermal expansion curves. The bonding the sealing glass and the substrate is thought to be occurred in the region, so-called a transition region, in the range from the glass transformation temperature (Tg) to the deformation temperature (Td) of the glass. The bonding point is expressed as a setting point, ($T_{set}$). The $T_{set}$ is a point where the stresses in the sealing glass and the substrate influence each other. Therefore, a stress caused from difference of the elongation of the sealing glass and the substrate in the subsequent cooling process can be estimated

by selecting the $T_{set}$ as a crossing point of the two curves.

After the sealing glass and the substrate are bonded at the $T_{set}$ in the case when holding at a temperature during the cooling period is not performed, the stress caused by the difference of the elongation s at room temperature is generated. When the sealed body is held at a temperature during the cooling period, for instance at T2, the viscosity of the glass in the transition region is as low as to make the internal stress to be relaxed, and the internal stress in the sealed body reaches zero at T2. When the sealed body is cooled down gradually from T2, a difference s of the elongation corresponding to the cooling process is generated, and a stress corresponding to s' is applied. In this case, s' is smaller than s, and the stress remained at room temperature is small.

Next, the case when the sealed body, which has been cooled down to room temperature without holding at a temperature during the cooling period, is re-heated to the temperature T2 is considered. The sealed body has a stress corresponding to s at room temperature. Accordingly, when the sealed body is re-heated to $T_{set}$, the stress becomes zero at the temperature. However, when the sealed body is cooled to room temperature, the stress corresponding to s is applied again. On the other hand, when the sealed body is held at the temperature T2, the stress can not be relaxed completely and remains somewhat, because the temperature is not sufficiently high. Therefore, when the sealed body is cooled further to room temperature from T2, the stress s" ($s' < s'' < s$) is remained.

Accordingly, the case when the sealed body is held at a temperature during the cooling period has a higher effect for relaxing the stress than the case when the sealed body is re-heated as shown in FIG. 10.

The stress was evaluated by measuring the retardation of the glass sealed body with a birefringence method using a monochrome light source. The retardation is a phase difference generated by variation of the refractive index in a stress axis direction of light incident into the glass wherein the stress is applied. The stress applied to the glass can be estimated by evaluating the amount of the retardation.

FIG. 12 indicates schematically the glass sealed body used for measuring the retardation. The substrate 1 of 1 mm thick was cut to approximately 5 mm square. A through hole of 2 mm in diameter was manufactured at the center of the substrate as a glass filling space. The substrate was placed on an aluminum foil, a glass cubicle of 2 mm cubic was placed in the hole, and remained space in the hole was filled with glass using the sealing profile shown in FIG. 8. After filling the glass, both faces of the substrate were mirror-polished to make a specimen for measuring the birefringence. A He-Ne laser of wave length 650 nm was used as the light source. The beam diameter of the laser was approximately 0.3 mm, and the measurement was performed by scanning the glass filled portion with approximately 0.1 mm intervals in a diametrical direction with the laser beam.

In accordance with the present embodiment, a Mn-Zn ferrite plate was used as the substrate, and the glass No. 6 and 7 were used. The cooling was performed with either of two cooling conditions. The one is rapid cooling, of which cooling velocity is 20 °C/minute, and the other is cooling with a cooling velocity of 2 °C/minute, and holding at a temperature which gives the least amount of warp of the glass.

FIG. 13 indicates results of measuring the stress by the birefringence method. The abscissa indicates the scanning distance when the laser beam scans the specimen shown in FIG. 12 in the diametrical direction, and the position at 1.0 mm is the center of the specimen. The ordinate indicates the retardation (R/nm). The retardation at the center of the glass was smallest in any conditions. However, large retardation were observed at the bonding boundary of the glass with the ferrite.

In comparison of the retardation at the bonding boundary, the glass No. 6 having a small thermal expansion coefficient had a smaller retardation than the glass No. 5, and the generated stress was also small. In comparison of the rapid cooling specimen with the specimen held at a temperature, the rapid cooling specimen had a larger retardation at the boundary, and a larger stress was applied. The above results coincided with the results of evaluation of the stress by the amount of the warp shown in FIG. 1.

A relationship between the retardation and the stress applied to the glass was investigated. The relationship between the stress applied to the glass and the retardation can be given by the following equation:

$$R = FCL \tag{1}$$

where, R: retardation (nm)
F: stress applied to the glass ($kg/cm^2$)
L: length of the specimen
C is a photoelastic constant, that is, a proportional constant specific to the kind of the glass.

The C of the glass No. 5 and 6 was approximately 0.58 $(nm/cm)/(kg/cm^2)$. The L was determined by an actual measurement as 0.99 cm. In the case of the glass No. 5 rapid cooling specimen, the retardation generated at the boundary was approximately 5.8 nm. By substituting the above values in the equation (1), the F was obtained as 9.1 MPa. On the other hand, in the case of the glass No. 6 cooling hold specimen, the retardation at the boundary was 0.8 nm, and the stress F was obtained as 1.5 MPa.

Considering that the stress is concentrated to a portion of a small radius of curvature, ρ, of the boundary, the F can be expressed by the following equation:

$$F \propto 1/\sqrt{\rho} \qquad (2)$$

In the present embodiment, the ρ is 1.0 mm. However, in cases of small electronic members studied in the present invention, the radius of curvature of the glass sealed portion were approximately 10 μm. Therefore, it can be considered that the stress generated at the glass sealed portion of the electronic members is almost ten times of the stress in the present embodiment. That means, in case of the No. 5 rapid cooling specimen, the stress is 91 MPa, and in case of the No. 6 cooling hold specimen, the stress is 15 MPa.

FIG. 14 indicates a weibull plot of the three points bending strength of the glass No. 5 and 6. Regarding the glass No. 5, it is expected that the stress of 91 MPa will destroy approximately 40 % of the specimens. On the other hand, the probability of destroying the glass No. 6 specimen by the stress of 15 MPa is approximately zero. Therefore, by using the glass No. 6, breakage of the glass sealed portion in the electronic members can be decreased significantly.

Furthermore, the glass sealed body (FIG. 12) using the glass No. 6 was re-heated to 435 °C, and cooled to room temperature with an average cooling velocity of 2 °C/minute. The holding at a temperature during the cooling period was not performed. The retardation before the re-heating was 0.8 nm, but after the reheating and the cooling, the retardation in the glass portion was increased to 1.7 nm. The retardation of the glass sealed body using the glass No. 5 and of rapid cooling was 5.8 nm, but after the re-heating as same as the above and the rapid cooling again, the retardation was 5.6 nm as approximately same as before the re-heating.

As explained above, the stress applied to the glass sealed body before re-heating was small, when the retardation, R1, of the glass portion at room temperature, and the retardation, R2, of the glass portion when the glass sealed body was heated at a temperature exceeding the deformation temperature of the sealing glass and cooled down to room temperature were in a relationship expressed by the following equation:

$$R1 < R2$$

In order to obtain the glass sealed body having a small stress as above, it was desirable to perform holding the glass sealed body at a temperature near the glass transformation temperature of the glass. The holding time was desirably at least 30 minutes at a temperature near the glass transformation temperature.

A magnetic head was prepared using the glass No. 5 and 6. FIG. 15 schematically illustrates a perspective view of the magnetic head. In FIG. 15, the numeral 1 indicates sealing glass, 11 is magnetic film, 2, 2' are Mn-Zn ferrite single crystal substrates, 13 is a gap portion, or a gap material, 14 is reaction preventing film, 15 is a coil winding window, 25, 25' are coils, and u is a sliding plane. As shown in FIG. 15, the magnetic head of the present invention has a structure, wherein the gap material 13, and the reaction preventing film 14 are sequentially formed on the magnetic film 11, which is formed on the substrate, and a pair of the above composed materials are butted each other and bonded with glass. The steps of manufacturing the magnetic head are shown in FIG. 16 and FIG. 17. Referring to FIG. 16 and FIG. 17, a manufacturing method of the magnetic head shown in FIG. 15 is explained hereinafter. First, the glass filling grooves 16, the coil winding window 15, and others were manufactured onto the Mn-Zn ferrite substrate 2 (FIG. 16 (a)). The magnetic film 11 was formed on the manufactured surface of the substrate by a spattering method. Subsequently, the $SiO_2$ gap material 13, and metallic chromium reaction preventing film 14 were formed sequentially on the gap material by the spattering method (FIG. 16(b)). The sealing glass film 9 was formed on a portion (rear portion) lower than the coil winding window by the spattering method with covering a portion nearer the sliding plane than the coil winding window 6 by a simple mask 10 (FIG. 16 (c)).

The C-core 2, whereon the coil winding window 15 was formed, and the I-core 2', whereon the coil winding window was not formed, were butted each other, a glass rod for sealing 17 was placed on a plane to be the sliding plane, and the glass was heated to be soften and to complete a glass bonding (FIG. 17 (a). After bonding, the tape sliding plane U was cylindrically polished (FIG. 17 (b)), and the magnetic head shown in FIG. 15 was obtained by cutting the composed body along the lines a-a, and b-b shown in FIG. 17 (a).

Table 3 indicates crack generation rates, head chip strengths, and magnetic characteristics of the manufactured magnetic head.

Table 3

| Glass No. | Cooling condition | Crack generation rate (%) | Head chip strength (gf) | Magnetic characteristics |
|---|---|---|---|---|
| 5 | Rapid cooling | 40 | 30 | △ |
| 6 | Cooling hold | 0 | 54 | ○ |

The crack generation rate was determined from the number of heads, which generated cracks, among the manufactured heads. The head chip strength was determined by compressing the head chip, which did not generate the cracks, in a direction perpendicular to the sliding plane and determining a load to break the head. The magnetic characteristics is expressed by ○ when it is desirable, and by △ when it is not desirable.

The case when the glass NO. 6 was used, holding a temperature during the cooling period was performed at 380 °C for 30 minutes, and the glass No. 5 was cooled rapidly. The crack generation rate of the glass No. 6 was zero, i.e. no cracks were generated. On the contrary, when the glass No. 5 was used and cooled rapidly, the cracks were generated in approximately 40 % of the manufactured head. The head chip strength of the glass No. 6 was as high as 54 gf, but that of the glass No. 5 was approximately a half of the glass No. 6. The magnetic characteristics was not desirable when the glass No. 5 was used.

The retardation of the glass was determined by cutting out a test piece from an upper portion of the coil winding window of the glass sealing portion of the manufactured magnetic head, and measuring the retardation using the test piece by a transmission method. The retardation of the magnetic head using the glass No. 6, which was held at a temperature during the cooling period, was less than 0.1 nm, and it was difficult to determine. This is because the stress applied to the glass was very small, and the amount of the filling glass was small. The retardation of the magnetic head using the glass No. 5, which was cooled rapidly, was 0.65 nm, and it was revealed that a large stress was applied to the glass.

Furthermore, the magnetic head using the glass No. 6 was re-heated to 435 °C, and cooled to room temperature with an average cooling velocity of 2 °C /minutes. The holding at a temperature during the cooling period was not performed in this case. The retardation of the glass portion of the magnetic head after cooled was 0.3 nm, and increased as larger than the retardation of before the re-heating. When the magnetic head using the glass No. 5, which was cooled rapidly, was re-heated as same as the above and cooled rapidly again, the retardation was 0.65 nm as same as before the re-heating.

As explained above, when the retardation, R1, of the glass portion at room temperature, and the retardation, R2, of the glass portion of the magnetic head, which was heated at a temperature exceeding the deformation temperature of the sealing glass and cooled down to room temperature, were in a relationship expressed by the equation, $R1 < R2$. The stress applied to the magnetic head before the re-heating was not significant, and the crack generation rate was desirable. The glass bonding strength was also desirable.

In order to obtain the magnetic head as above, it was desirable to perform holding at a temperature in the range of the glass transformation temperature of the glass ± 10 °C during the cooling period. The holding time was desirably for more than 30 minutes at the temperature near the glass transformation temperature of the glass.

A large number of cracking failure were generated, when the sealing glass having a thermal expansion coefficient larger than 95 % of the thermal expansion coefficient of the ferrite substrate such as the glass No. 5 was used. When the sealing glass having a thermal expansion coefficient smaller than 70 % of that of the ferrite substrate was used, the magnetic head, of which magnetic characteristics was not desirable, was obtained. Therefore, the sealing glass for the magnetic head has preferably a thermal expansion coefficient in the range of 70 ~ 95 % of the thermal expansion coefficient of the substrate.

As explained above, in accordance with the magnetic head and the manufacturing method of the same, the stress applied to the glass portion could be decreased, and the production yield, the reliability, and the performance of the magnetic head were improved.

FIG. 18 indicates a schematic cross section of a plasma display panel manufactured in the present embodiment. In FIG. 18, the numeral 31 indicates sealing glass, 32 is a front panel glass, 33 is a back panel glass, 34 is a separator, 35 is a discharge cell, 36 is a display electrode, 37 is a bus electrode, 38 is a dielectric film, 39 is a MgO protection film, 310 is an address electrode, and 311 is a fluorescent body.

In the present embodiment, a soda lime glass plate having a thermal expansion coefficient of $85 \times 10^{-7}$/°C was used as materials for the front and back panel glasses and the separator. For sealing glass, $PbO-B_2O_3$ glass containing $PbTiO_3$ as a filler, of which thermal expansion coefficient was $70 \times 10^{-7}$ /°C, was used. A separator was formed on the back panel, whereon the address electrode had been formed, and fluorescent substance of three primary colors were applied onto the back panel and the separator. The sealing glass was arranged at four sides of the back panel glass in order to surround the separator. The front panel glass, whereon the display electrode, the bus electrode, the dielectric film, and the MgO protection film had been formed, was placed on the back panel glass, and the whole body was heated at 435 °C for 30 minutes to seal the whole body.

Two kinds of the panels were manufactured. The one was held at 310 °C, which was the glass transformation temperature of the sealing glass, for one hour during the cooling period, and the other one was not held at any specific temperature during the cooling period.

The bonding strength of the glass sealed portion of the plasma display panels manufactured by the above two cooling modes different from each other were evaluated. A test piece was cut out from the glass sealed portion of the panel, and the bonding strength was evaluated by compressing the test piece in a direction parallel to the bonded plane and determining a load to break the bonded plane.

The bonding strength of the bonded plane of the glass sealed portion of the plasma display panel held at a holding temperature during the cooling period was 25 MPa, and that of the plasma display panel which was not held at the holding temperature was 18 MPa. That is, in accordance with holding at the holding temperature during the cooling period, the bonding strength was increased approximately 28 %. The reason is considered that the stress applied to the sealing glass can be relaxed by the holding at the holding temperature during the cooling period. In order to verify the above consideration, the retardation was evaluated by projecting a laser beam of wave length 650 nm to the front panel glass near the sealing portion. The transparency of the sealing glass was insufficient for determining the retardation, because it contained a filler material. Therefore, the stress in the panel glass was evaluated.

The retardation of the panel, which was manufactured without holding at the holding temperature, was -5.0 nm, and it was found that a large compressive stress was applied to the panel glass. Therefore, reversely, it could be assumed that a tensile stress corresponding to the retardation of -5.0 nm was applied to the sealing glass.

On the other hand, the retardation of the panel, which was manufactured with holding at the holding temperature during the cooling period, was -2.5 nm, approximately a half of the above case. Accordingly, it was found that the tensile stress applied to the sealing glass was also decreased. The glass sealed portion of the panel glass was re-heated to 330 °C, which was higher than the deformation temperature of the sealing glass of 318 °C, and cooled by 2 °C/minute. The retardation of the re-heated glass sealed portion was determined. The retardation was -5.0 nm, and a compressive stress as same as the panel glass, which was obtained without the holding at the holding temperature, was generated.

As explained above, the plasma display panel of the present invention had a relationship expressed by the equation, $R2_s < R1_s$, where, $R1_s$ is the retardation of the glass sealed portion of the panel glass at room temperature, and $R2_s$ is the retardation of the glass sealed portion after re-heating and cooling to room temperature.

In this case, the stress applied to the glass sealed portion of the panel glass before the re-heating was small, and the bonding strength was large. In order to obtain the plasma display panel of the present invention, the plasma display panel was desirably held at a temperature near the glass transformation temperature of the sealing glass for a definite time during the cooling period. The temperature to be held was desirably in the range of the glass transformation temperature ± 10 °C. When the thermal expansion coefficient of the sealing glass was in the range of 70 ~ 95 % of that of the substrate, generation of the cracks, and the like were not observed as same as the case of the magnetic head, and a preferable results were obtained.

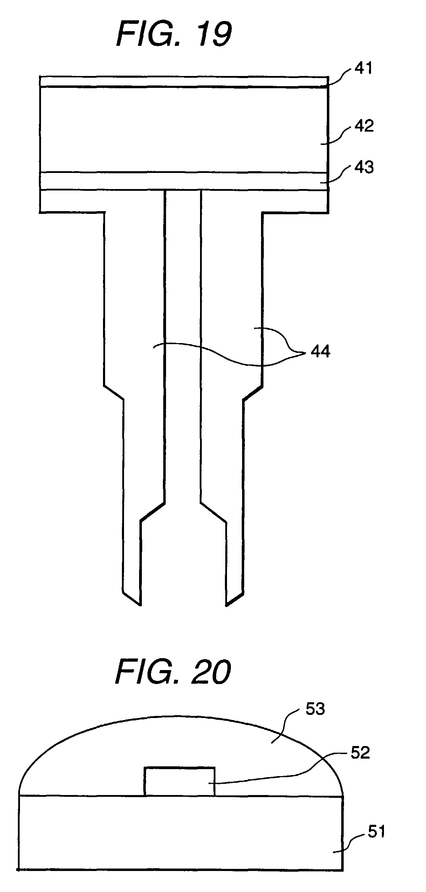

FIG. 19 indicates a schematic cross section of a semiconductor sensor manufactured by the present invention. In FIG. 19, the numeral 41 indicates a sensor, 42 is pyrex glass, 43 is sealing glass, and 44 is a metallic post. A semiconductor substrate was manufactured by patterning a sensor circuit on a Si wafer. A pyrex glass plate (thermal expansion coefficient: 30 X $10^{-7}$/°C) of the same size with the substrate was arranged under the semiconductor substrate, and an anodic bonding was performed by supplying electric current.

Then, the substrate was cut out to each of semiconductor chips. The chip was arranged onto a Fe-Ni-Co group metallic post via a sealing glass pre-formed body, and sealed by heating under a condition of 440 °C -20 minutes. For the sealing glass, PbO - $B_2O_3$ group bonding glass containing $PbTiO_3$ as a filler was used. The thermal expansion coefficient of the glass was 37 X $10^{-7}$/°C. Two kinds of specimens different each other in the cooling condition were manufactured. The one was manufactured by holding at 310 °C, which was the glass transformation temperature of the glass, for 30 minutes during the cooling period, and another one was manufactured without holding at a temperature during the cooling.

Regarding the chip held at 310 °C, a preferable result was obtained with less fluctuation in characteristics of respective chips in comparison with the chip which was not held at a temperature during the cooling period. In accordance with evaluating the stress in the pyrex glass portion by the retardation, it was found that the stress applied to the sensor portion was relaxed by holding at a temperature during the cooling period. Furthermore, the stress applied to the chip was found to be homogenized.

The semiconductor sensor manufactured by holding at a temperature during the cooling period was re-heated and cooled without holding at a temperature. Then, the retardation of the pyrex glass of the above re-heated semiconductor sensor was determined. As the result, a relation expressed by the equation, $R2_s < R1_s$, was confirmed to be established

between the $R1_s$, which was the retardation of the pyrex glass before the re-heating, and the $R2_s$, which was the retardation after the re-heating. Accordingly, in accordance with the semiconductor sensor explained above, semiconductor chips, of which fluctuation in characteristics per each chip is small, can be obtained.

In order to obtain such semiconductor chip as above, the chip is desirably held at a temperature in the range of the glass transformation temperature of the using sealing glass ± 10 °C during the cooling period. The reason is as same as the embodiment of the glass sealed body explained previously. As explained above, in accordance with the semiconductor sensor of the present invention, the semiconductor sensors having an uniform characteristics could be obtained.

FIG. 20 indicates a schematic illustration of an optical wave guide, i.e. an example of optical devices manufactured by the present invention. In FIG. 20, the numerical 51 indicates a glass substrate, 52 is a core glass of a wave guide path, and 53 is cover glass. For the glass substrate, boron-silicate glass having a thermal expansion coefficient of 51 X $10^{-7}$/°C was used. The refractive index of the boron-silicate glass to monochrome light of wave length 635 nm was 1.49. Soda lime glass film having a thermal expansion coefficient of 85 X $10^{-7}$/°C was formed onto the glass substrate as glass for a wave guide path by a deposition method. The refractive index of the soda lime glass to monochrome light of wave length 635 nm was 1.53.

After forming the film, the whole body was heated to 600 °C to soften the glass film of the wave guide path, in order to densify the film. Then, two kinds of specimens different each other in the cooling condition were manufactured. The one was manufactured by holding at 550 °C, which was the glass transformation temperature of the glass film, for one hour during the cooling period, and another one was manufactured without holding at a temperature during the cooling. After densification, a patterning was performed so as to form a desired wave guide path. Furthermore, a cover glass was formed onto the surface by a deposition method to obtain the optical wave guide path shown in FIG. 20.

Then, an optical loss of the manufactured optical wave guide path was evaluated taking the length of the wave guide path as 10 cm. The optical loss of the specimen which was held at a temperature during the cooling period was decreased to less than that of the specimen which was not held at a temperature. The evaluation of retardation of the wave guide path portion revealed that the stress in the wave guide path portion was decreased by holding the specimen at a temperature during the cooling period. The decrease in optical loss of the specimen can be understood to be caused by the decrease in stress.

The specimen manufactured by holding at a temperature during the cooling period was re-heated and cooled without holding at a temperature, as same as the previous embodiments. Then, the retardation of the above re-heated specimen was determined. As the result, a relation expressed by the equation, $R1 < R2$, was confirmed to be established between the R1, which was the retardation of the specimen before the re-heating, and the R2, which was the retardation of the specimen after the re-heating. The optical device such as above was found to have a small optical loss. In order to obtain an optical device such as above, the device is desirably held at a temperature in the range of glass transformation temperature of the core glass of the wave guide path ± 10 °C during the cooling period. As explained above, the stress of the optical device of the present invention was decreased and the optical loss was reduced.

Furthermore, the present invention is applicable to components and products, which are bonded and/or sealed with glass, other than the above magnetic heads, plasma display panels, semiconductor sensors, and optical devices.

In accordance with the glass sealed body and a method of manufacturing the same of the present invention, the stress applied to the glass sealed body could be reduced, and the mechanical strength and the characteristics of the members could be improved. Furthermore, the fluctuation of the characteristics of the products could be reduced, and the production yield of the products could be increased.

In accordance with the glass sealed body and the method of manufacturing the same of the present invention, the stress generated in the glass portion of the glass sealed body can be controlled in the wide range from tensile to compressive. In accordance with the magnetic head and the method of manufacturing the same of the present invention, the magnetic head of desirable production yield, reliability, and performance can be obtained. In accordance with the plasma display panel and the method of manufacturing the same of the present invention, the bonding strength is increased, and increasing the size of the panel can be acceptable.

In accordance with the semiconductor sensor of the present invention, the fluctuation of the sensing characteristics can be suppressed, and the production yield can be increased. In accordance with the optical devices of the present invention, the optical loss caused by stress can be suppressed, and the gain can be increased.

## Claims

**1.** A glass sealed body comprising:

at least a glass (1, 31, 43, 53) and
a substrate (2, 33, 42, 51), which is sealed with said glass,

wherein

said glass has a relationship expressed by the following equation;

$$R1 < R2$$

where,

R1: a retardation of said glass at room temperature, and

R2: a retardation of said glass after re-heating said glass sealed body at a temperature exceeding the deformation temperature of said glass, and subsequently cooling to room temperature by an average cooling velocity of utmost 20 °C/minute.

**2.** A method of manufacturing a glass sealed body comprising the steps of:

contacting a sealing glass with a substrate,
heating said sealing glass at a temperature exceeding the deformation temperature of the glass,
cooling said sealing glass to a temperature between the deformation temperature of the glass and room temperature with an average cooling velocity of utmost 20 °C/minute,
subsequently, holding said sealing glass for a predetermined time at a temperature in the range of the glass transformation temperature ± 10 °C of the glass, and
cooling said sealing glass from the holding temperature to room temperature with an average cooling velocity of utmost 20 °C/minute.

**3.** A method of manufacturing a glass sealed body as claimed in claim 2, wherein

a thermal expansion coefficient of said sealing glass is in the range of 65 ~ 105 % of the thermal expansion coefficient of the substrate.

**4.** A magnetic head comprising;

at least two magnetic cores (2, 2'), which are butted each other, and sealed with a sealing glass (1), wherein

said sealing glass has a relationship expressed by the following equation;

$$R1 < R2$$

where,

R1: a retardation of said glass at room temperature, and

R2: a retardation of said glass after re-heating said magnetic head at a temperature exceeding the deformation temperature of said glass, and subsequently cooling to room temperature by an average cooling velocity of utmost 20 °C/minute.

**5.** A method of manufacturing a magnetic head comprising the steps of;

butting at least two magnetic cores, and contacting the magnetic cores with a sealing glass,
heating said sealing glass at a temperature exceeding the deformation temperature of the glass,
cooling said sealing glass to a temperature between the deformation temperature of the glass and room temperature with an average cooling velocity of utmost 20 °C/minute,
subsequently, holding the sealing glass for a predetermined time at a temperature in the range of the glass transformation temperature ± 10 °C of the glass, and
cooling the sealing glass from the holding temperature to room temperature with an average cooling velocity of utmost 20 °C/minute.

**6.** A method of manufacturing a magnetic head as claimed in claim 5, wherein

a thermal expansion coefficient of said sealing glass is in the range of 70 ~ 95 % of the thermal expansion coefficient of the magnetic head.

**7.** A plasma display panel comprising:

a discharge cell (35), which is partitioned with a separator (34) and applied with a fluorescent substance (311), and
two glass plates (32, 33), which hold said discharge cell between them, and electrodes (36, 37, 310) and dielectric films (38) are formed on inner walls of said glass plates, and
said two glass plates are bonded to the discharge cell with a sealing glass (31), wherein
said plasma display panel has a relationship expressed by the following equation;

$$R2_s < R1_s$$

where,

$R1_s$: a retardation of said glass plate after sealed, and
$R2_s$: a retardation of said glass plate after re-heating said plasma display panel after sealed at a temperature exceeding the deformation temperature of said sealing glass, and subsequently cooling to room temperature by an average cooling velocity of utmost 20 °C/minute.

**8.** A method of manufacturing a plasma display panel comprising the steps of:

forming a separator,
applying a fluorescent substance onto a discharge cell partitioned with said separator,
forming electrodes and dielectric films on glass plates,
holding the separator with said glass plates between and arranging a sealing glass having a thermal expansion coefficient in the range of 70 ~ 95 % of the thermal expansion coefficient of said glass plate around said glass plates,
heating the whole body at a temperature exceeding the deformation temperature of said sealing glass for sealing the whole body,
cooling the whole body to a temperature in the range of the glass transformation temperature ± 10 °C of the glass with an average cooling velocity of utmost 20 °C/minute,
subsequently, holding the whole body for a predetermined time at a temperature in the range of the glass transformation temperature ± 10 °C of the glass, and
cooling the whole body to room temperature with an average cooling velocity of utmost 20 °C/minute.

**9.** A semiconductor sensor comprising:

at least a metallic post (44),
a semiconductor substrate whereon a sensor (41) is formed,
a glass plate (42) which is bonded to the back face of said semiconductor substrate, and
a sealing glass (43) which seals said metallic post and said glass plate, wherein
said semiconductor sensor satisfied a relationship expressed by the following equation;

$$R2_s < R1_s$$

where,

$R1_s$: a retardation of said glass plate after sealed, and
$R2_s$: a retardation of said glass plate after re-heating said semiconductor sensor at a temperature exceeding the deformation temperature of said sealing glass, and subsequently cooling to room temperature by an average cooling velocity of utmost 20 °C/minute.

**10.** A method of manufacturing a semiconductor sensor comprising the steps of:

bonding a semiconductor substrate, whereon a sensor is formed, with a glass plate,
arranging a sealing glass between a metallic post and said glass plate,
heating the whole body at a temperature exceeding the deformation temperature of said sealing glass for sealing the whole body,
cooling the whole body to a temperature in the range of the glass transformation temperature ± 10 °C of said sealing glass with an average cooling velocity of utmost 20 °C/minute,
subsequently, holding the whole body for a predetermined time at a temperature in the range of the glass transformation temperature ± 10 °C of said sealing glass, and
cooling the whole body to room temperature with an average cooling velocity of utmost 20 °C/minute.

**11.** An optical device comprising:

at least a glass substrate (51), whereon a glass wave guide film (52) is formed, and
a cover glass film (53) covering said glass wave guide film, wherein
said optical device has a relationship expressed by the following equation;

$$R1 < R2$$

where,

R1: a retardation of said glass wave guide path at room temperature, and
R2: a retardation of said glass wave guide path after re-heating said optical device at a temperature exceeding the deformation temperature of said glass wave guide path, and subsequently cooling to room temperature by an average cooling velocity of utmost 20 °C/minute.

**12.** A method of manufacturing an optical device comprising the steps of:

forming a glass wave guide film on a glass substrate,
heating the whole body at a temperature exceeding the deformation temperature of said glass wave guide film for densifying the glass wave guide film,
cooling the whole body to a temperature in the range of the glass transformation temperature ± 10 °C of said glass wave guide film with an average cooling velocity of utmost 20 °C/minute,
subsequently, holding the whole body for a predetermined time at a temperature in the range of the glass transformation temperature ± 10 °C of said glass wave guide film,
cooling the whole body to room temperature with an average cooling velocity of utmost 20 °C/minute,
shaping said glass wave guide film into a shape of wave guide path, and
forming a cover glass film onto the upper surface of the body.

FIG. 1

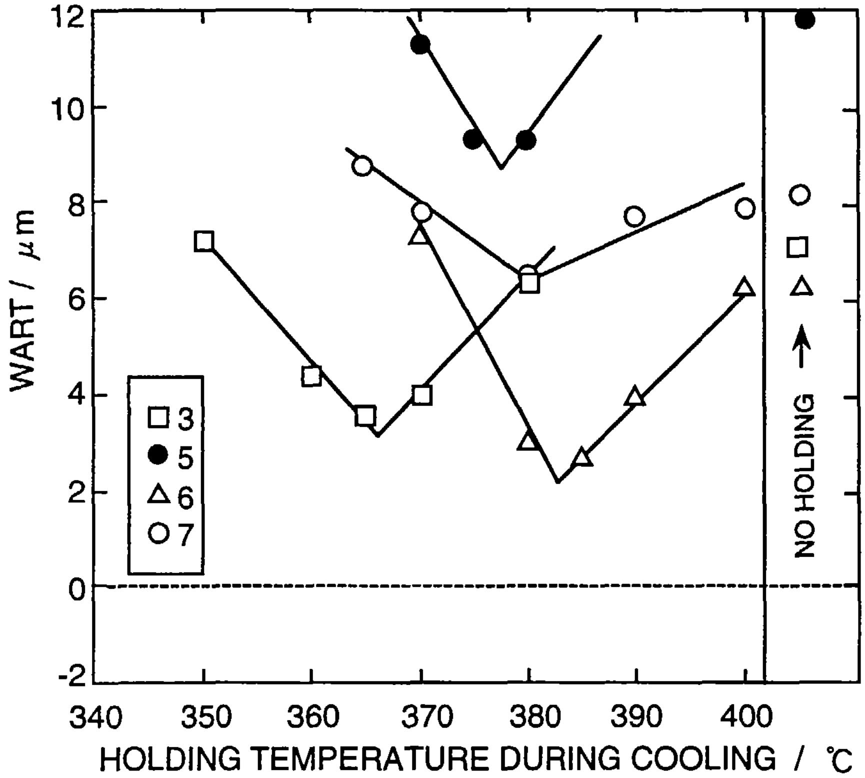
12
10
8
6
4
2
0
-2
WART / μm
□ 3
● 5
△ 6
○ 7
NO HOLDING
340
350
360
370
380
390
400
HOLDING TEMPERATURE DURING COOLING / ℃

FIG. 2

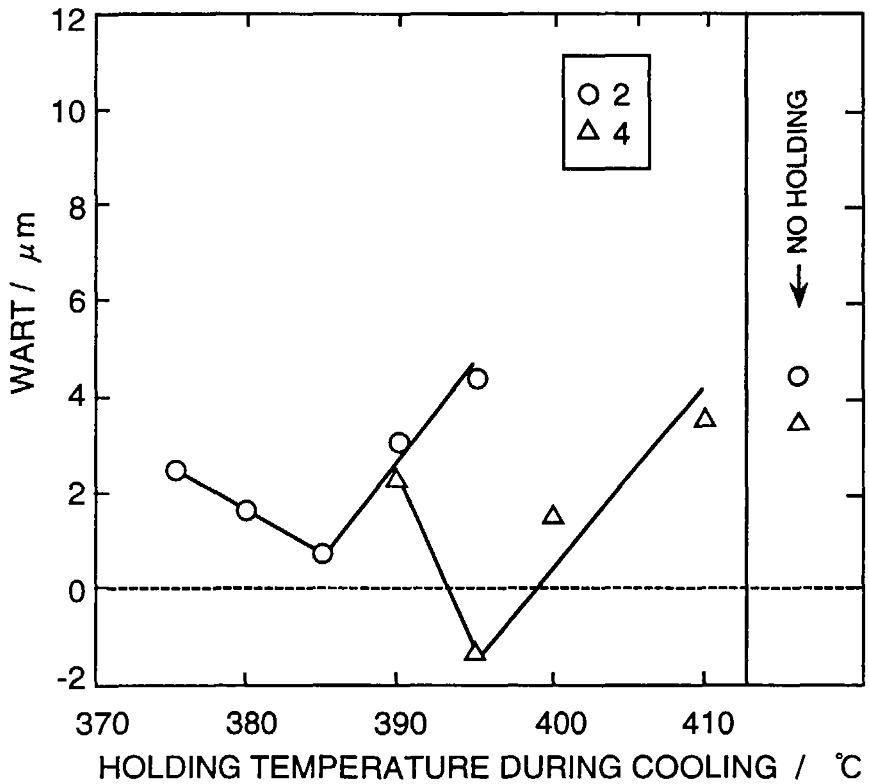
12
10
8
6
4
2
0
-2
WART / μm
○ 2
△ 4
NO HOLDING
370
380
390
400
410
HOLDING TEMPERATURE DURING COOLING / ℃

FIG. 3

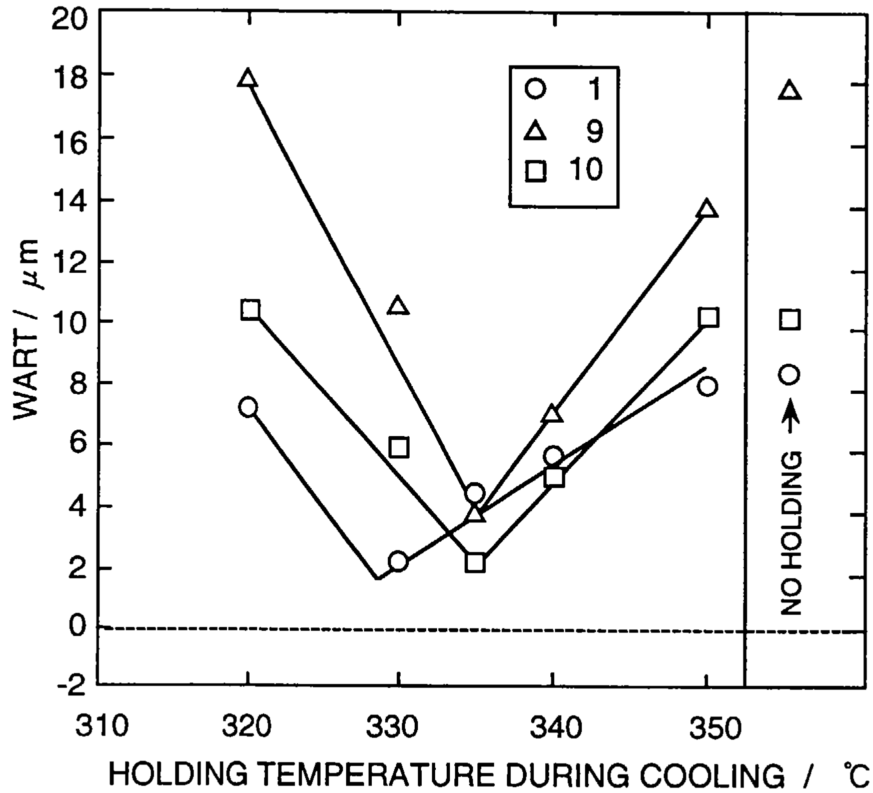
20
18
16
14
12
10
8
6
4
2
0
-2
WART / μm
310
320
330
340
350
HOLDING TEMPERATURE DURING COOLING / ℃
1
9
10
NO HOLDING

FIG. 4

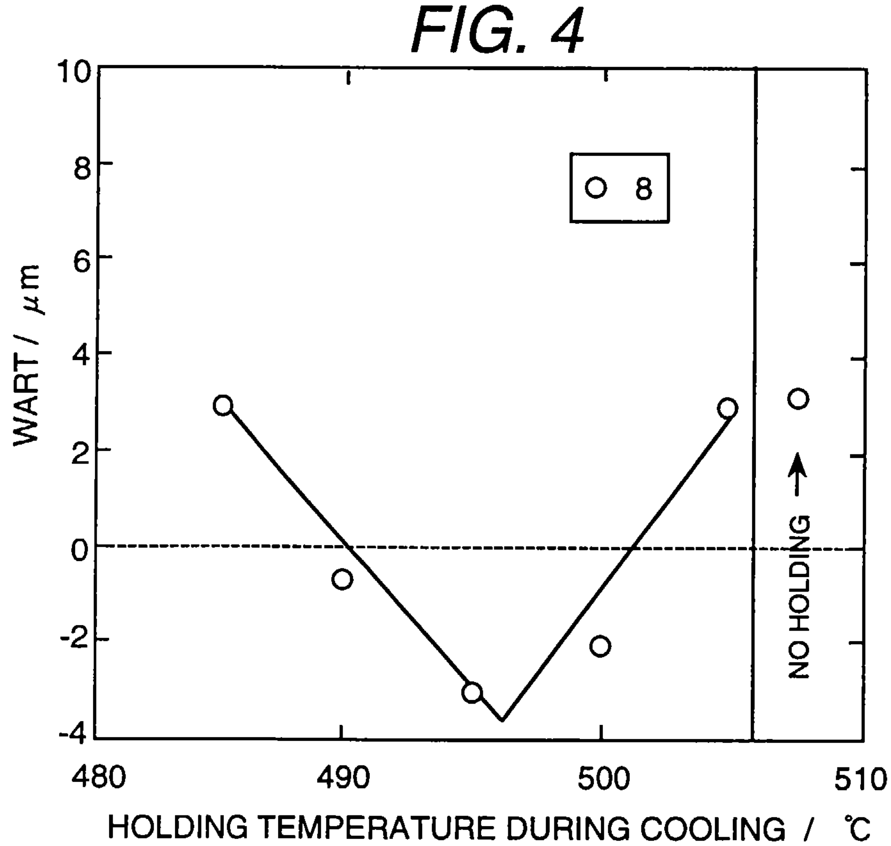
10
8
6
4
2
0
-2
-4
WART / μm
480
490
500
510
HOLDING TEMPERATURE DURING COOLING / ℃
8
NO HOLDING

FIG. 5

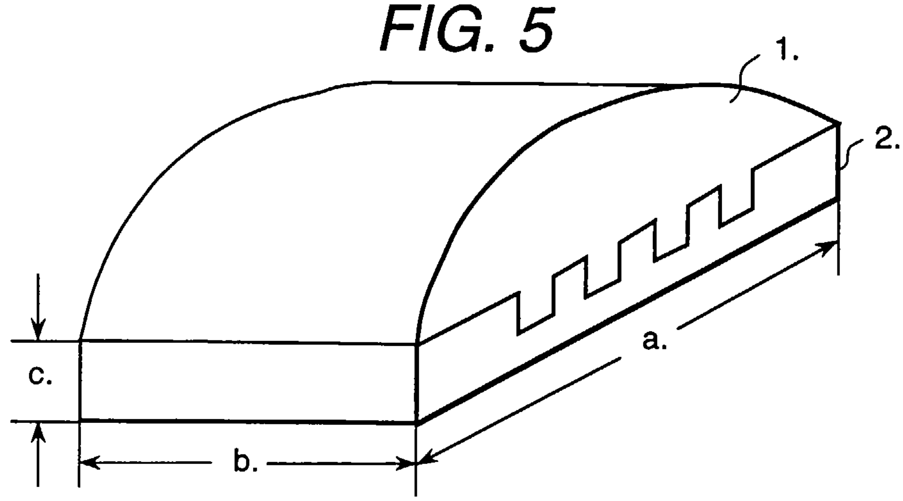


FIG. 6

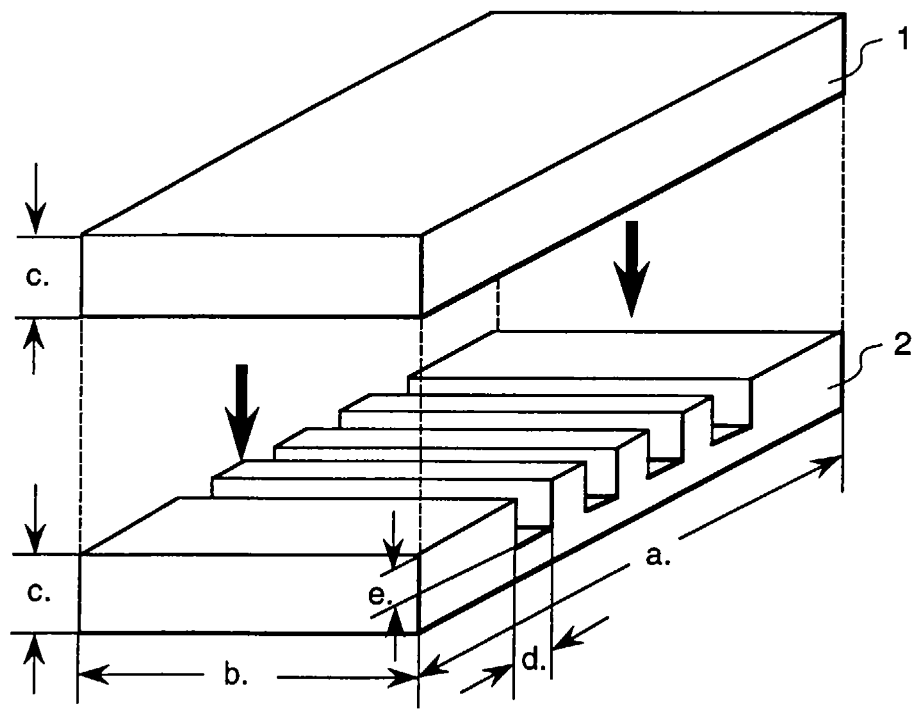

FIG. 7(a)

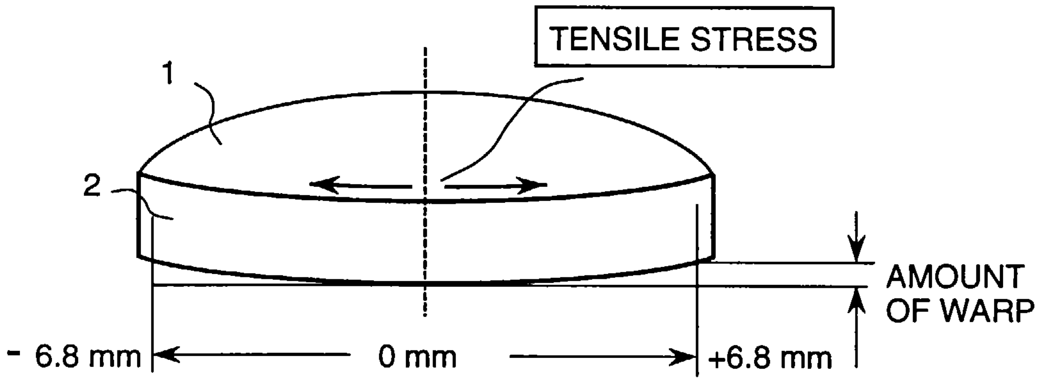


(a) WARP OF +

FIG. 7(b)

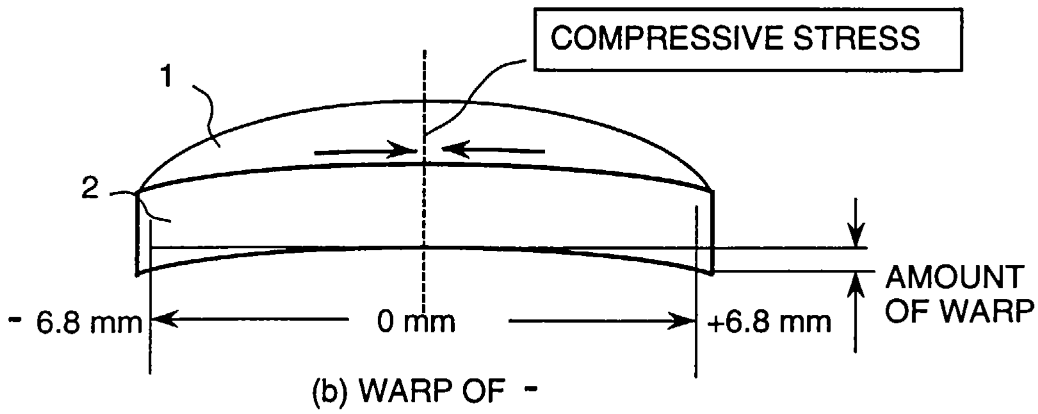


(b) WARP OF -

FIG. 8

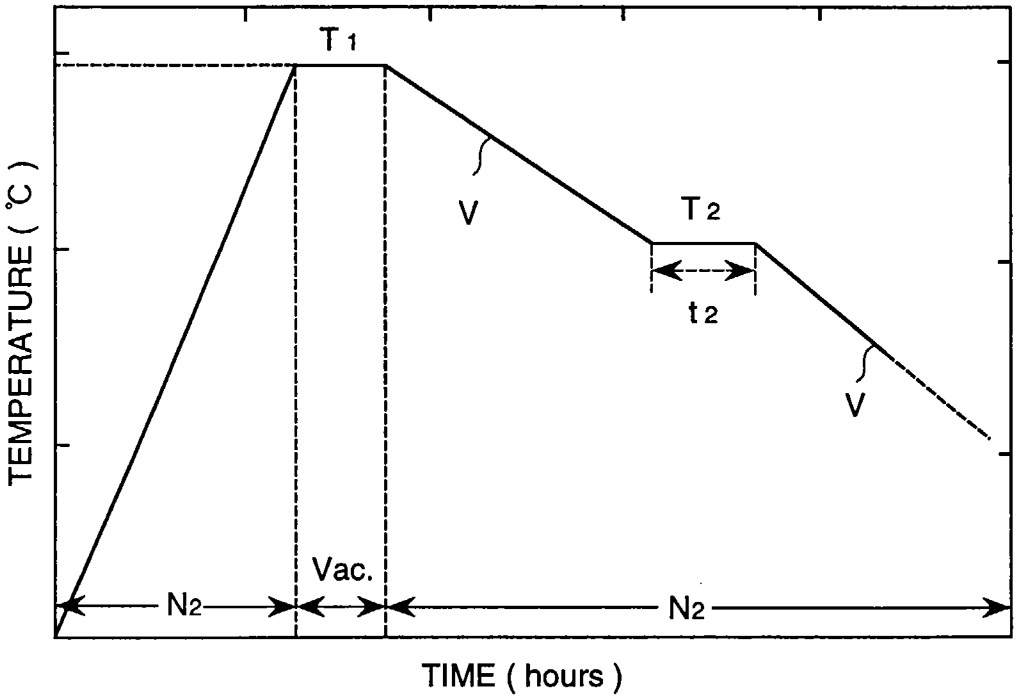
T 1
T 2
V
V
t 2
TEMPERATURE ( ℃ )
Vac.
N2
N2
TIME ( hours )

FIG. 9

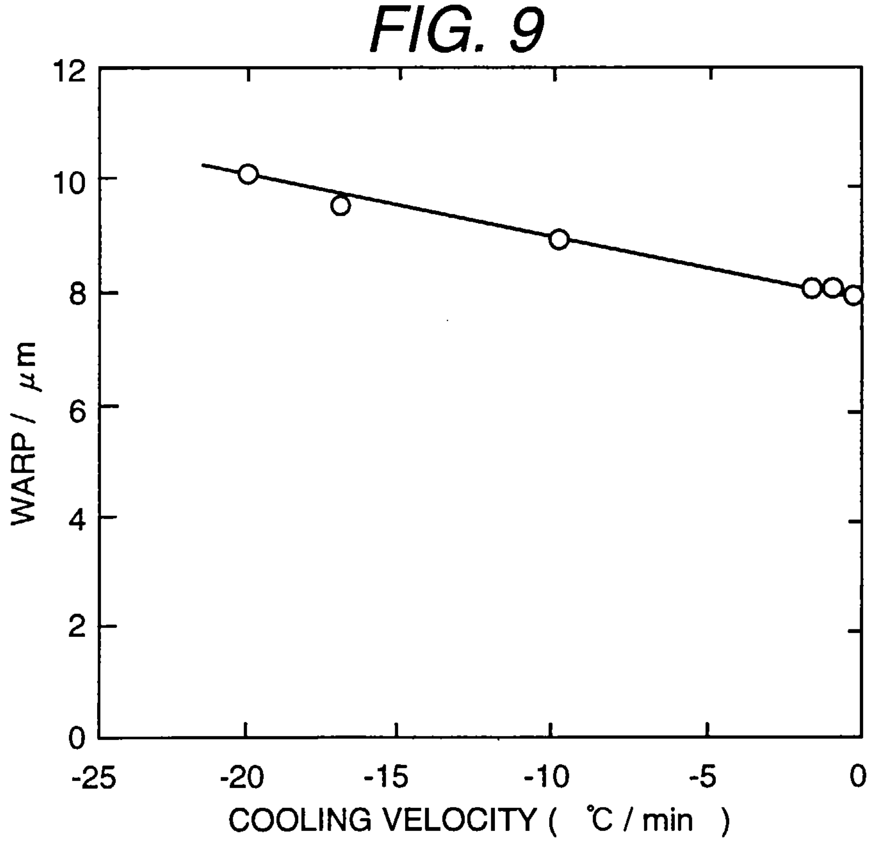
12
10
8
6
4
2
0
WARP / μm
-25
-20
-15
-10
-5
0
COOLING VELOCITY ( ℃ / min )

*FIG. 10*

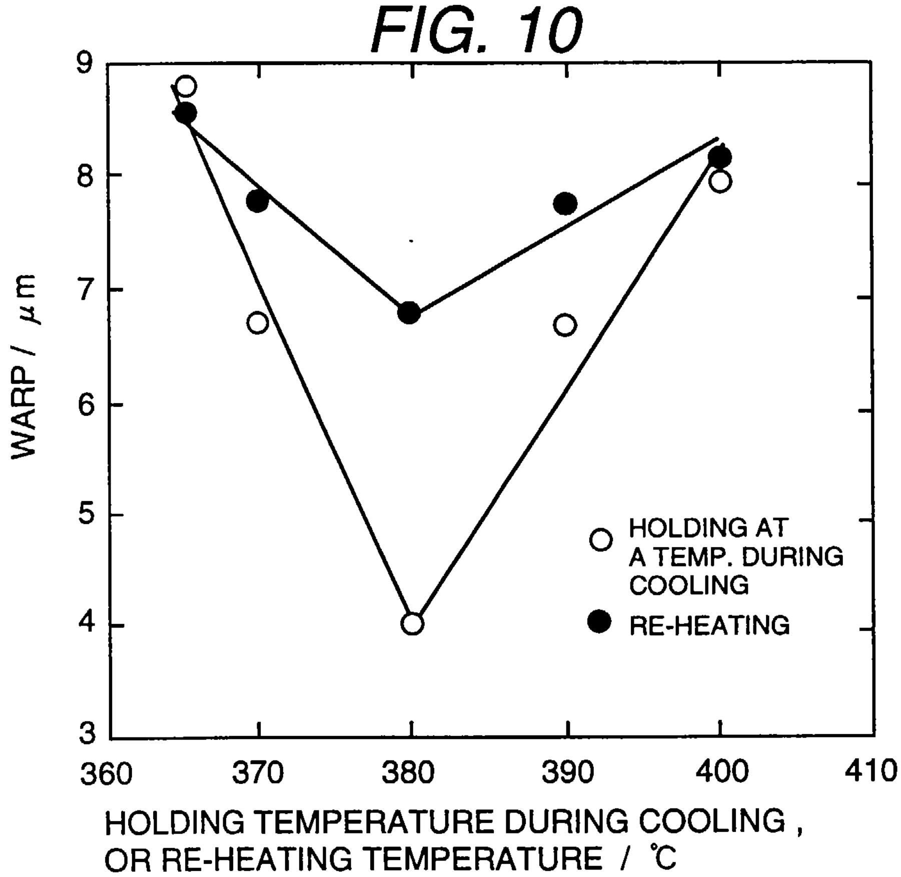
9
8
7
6
5
4
3
WARP / μm
360
370
380
390
400
410
HOLDING TEMPERATURE DURING COOLING ,
OR RE-HEATING TEMPERATURE / ℃
HOLDING AT
A TEMP. DURING
COOLING
RE-HEATING

*FIG. 11*

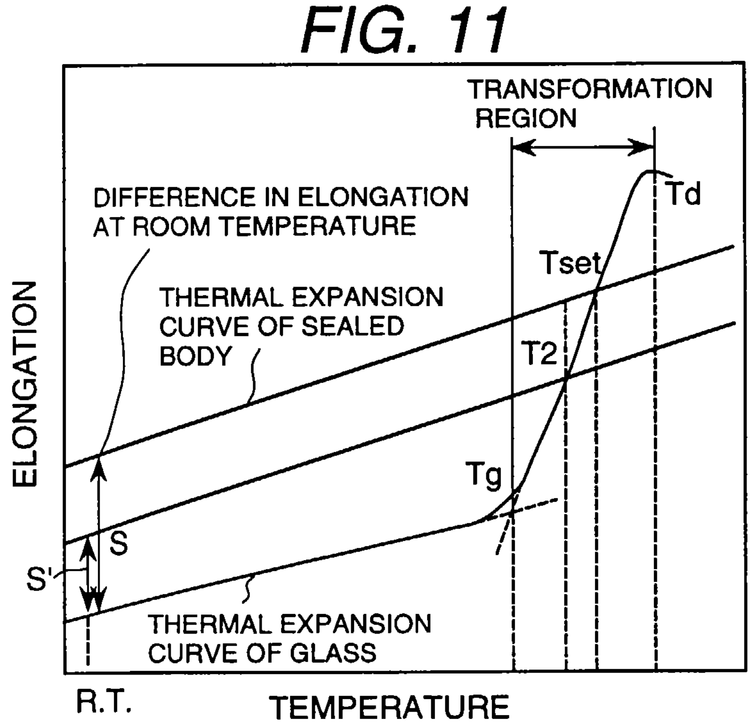
TRANSFORMATION
REGION
DIFFERENCE IN ELONGATION
AT ROOM TEMPERATURE
Td
Tset
THERMAL EXPANSION
CURVE OF SEALED
BODY
T2
ELONGATION
Tg
S
S'
THERMAL EXPANSION
CURVE OF GLASS
R.T.
TEMPERATURE

FIG. 12

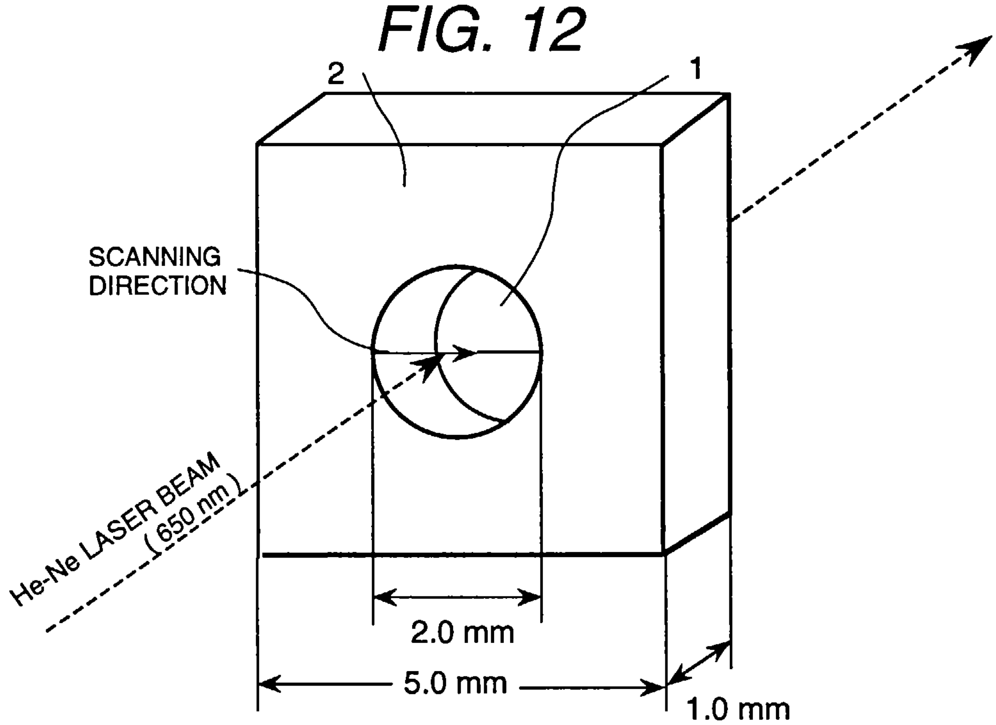
2
1
SCANNING
DIRECTION
He-Ne LASER BEAM
( 650 nm )
2.0 mm
5.0 mm
1.0 mm

FIG. 13

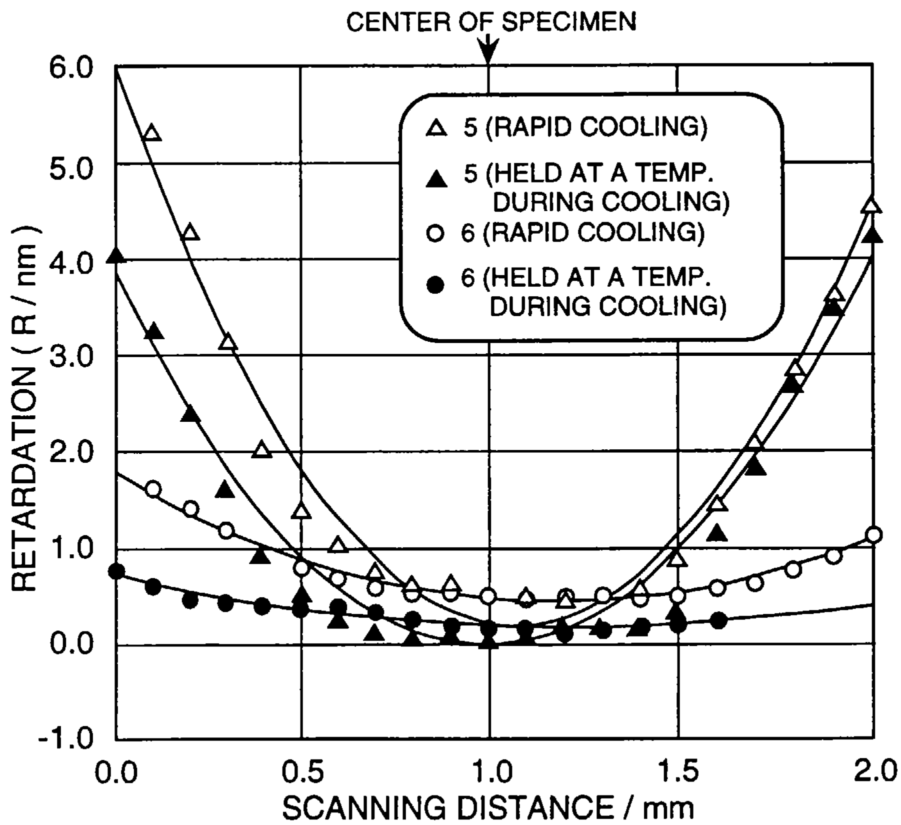
CENTER OF SPECIMEN
6.0
5.0
4.0
3.0
2.0
1.0
0.0
-1.0
RETARDATION ( R / nm )
△ 5 (RAPID COOLING)
▲ 5 (HELD AT A TEMP. DURING COOLING)
○ 6 (RAPID COOLING)
● 6 (HELD AT A TEMP. DURING COOLING)
0.0
0.5
1.0
1.5
2.0
SCANNING DISTANCE / mm

FIG. 14

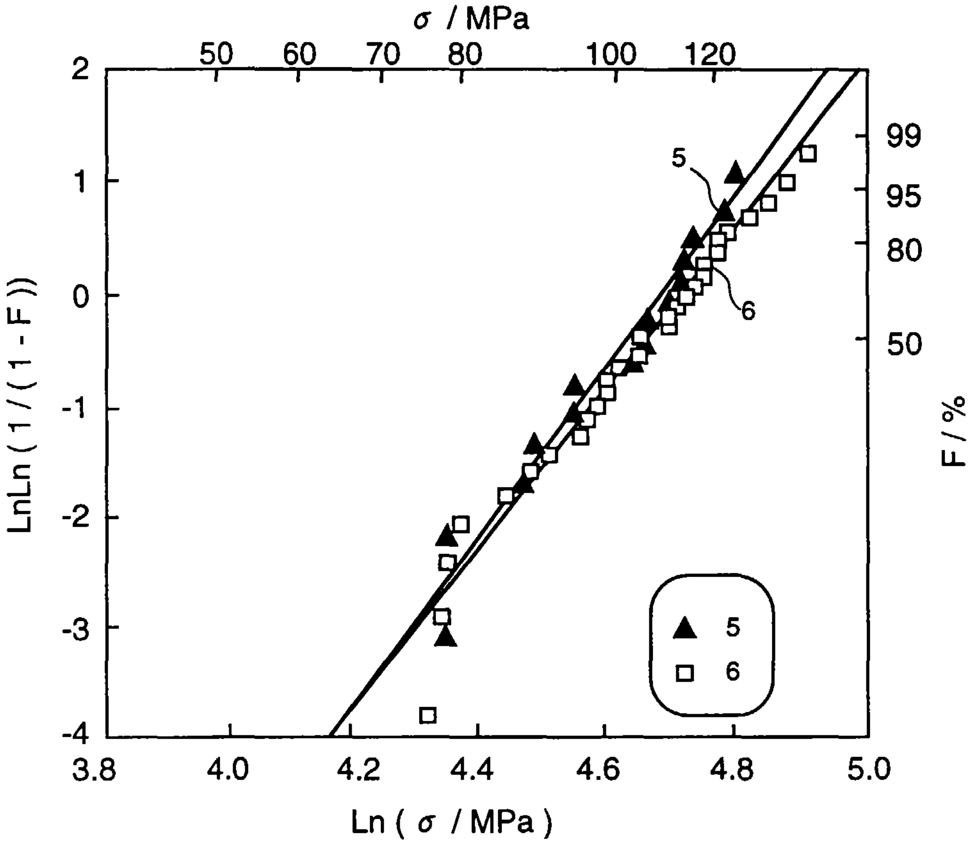
σ / MPa
50
60
70
80
100
120
2
1
0
-1
-2
-3
-4
LnLn ( 1 / ( 1 - F ))
99
95
80
50
F / %
5
6
▲ 5
□ 6
3.8
4.0
4.2
4.4
4.6
4.8
5.0
Ln ( σ / MPa )

FIG. 15

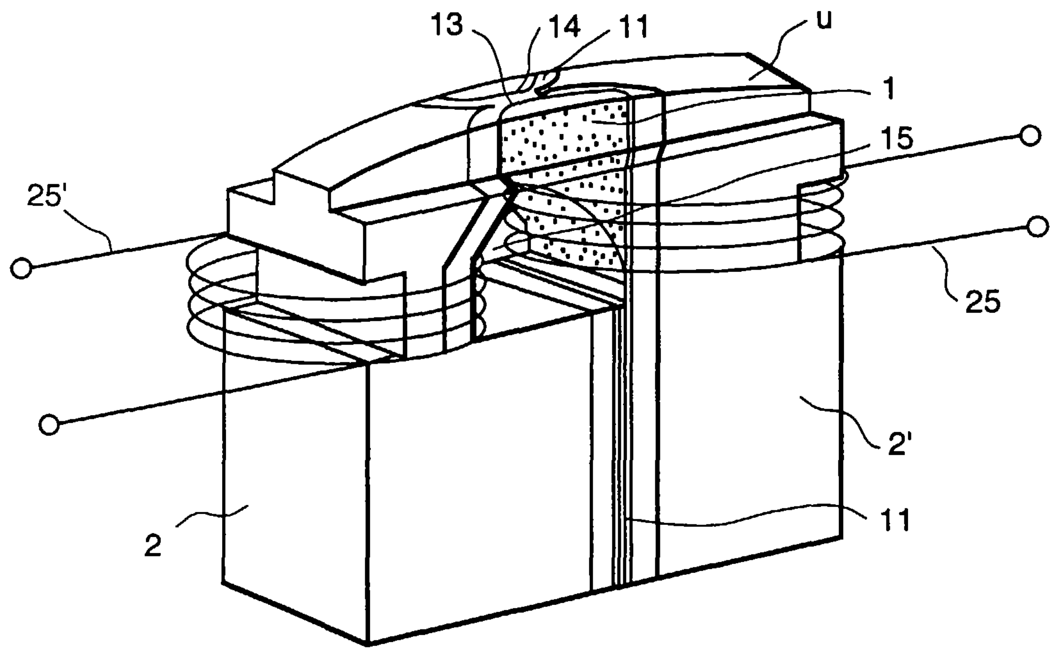
13
14
11
u
1
15
25'
25
2'
11
2

FIG. 16 (a)

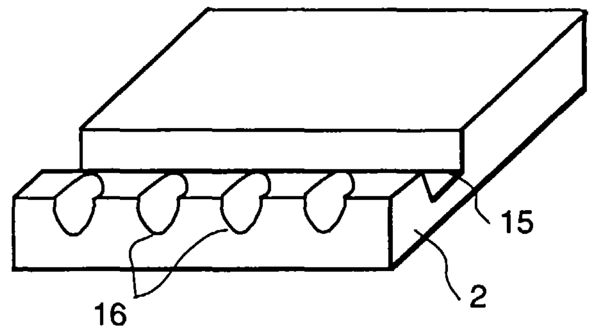


FIG. 16 (b)

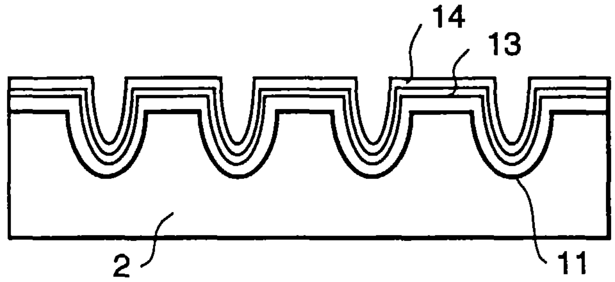


FIG. 16 (c)

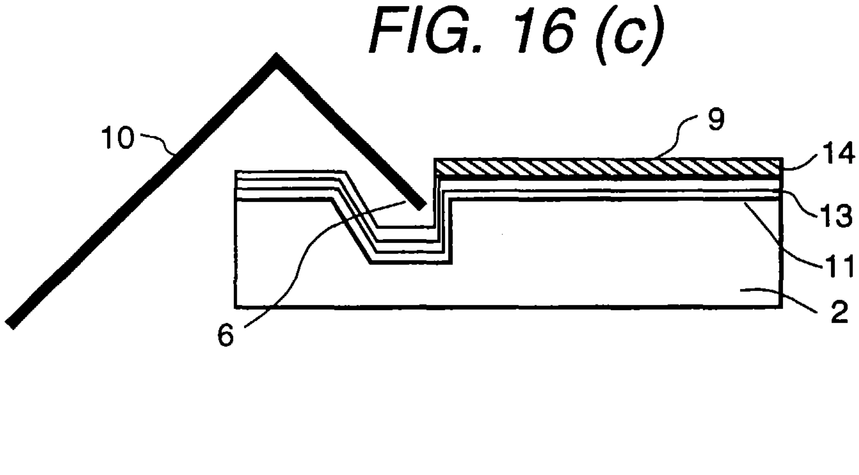

FIG. 17 (a)

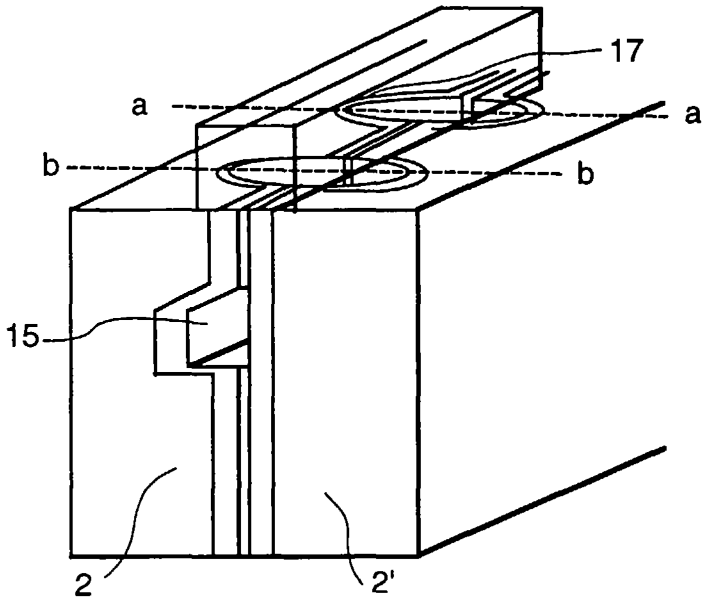


FIG. 17 (b)

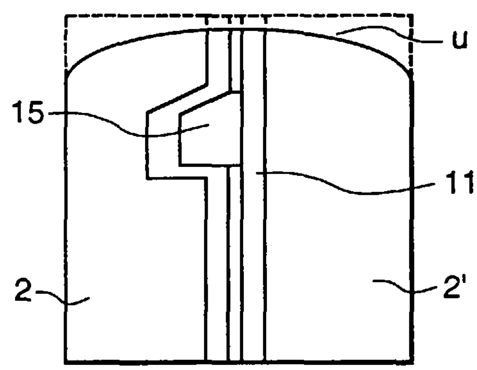

FIG. 18

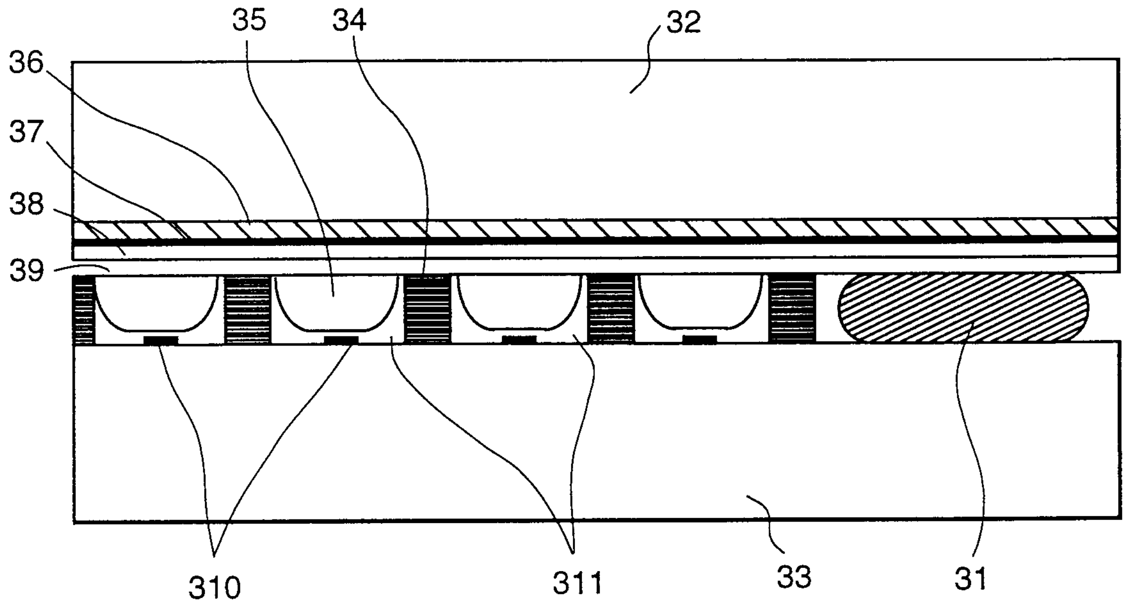

FIG. 19

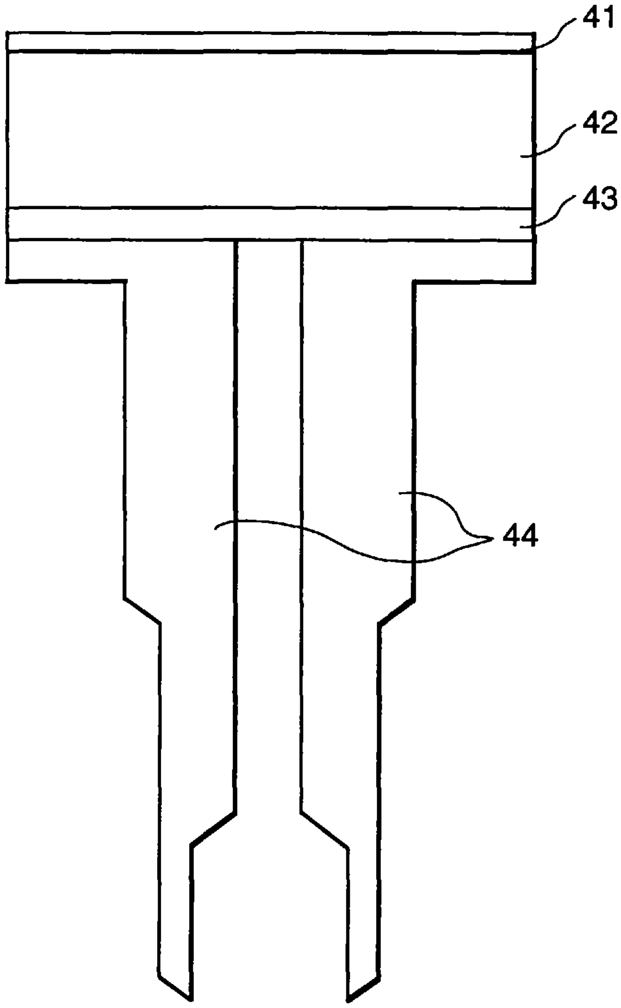


FIG. 20